# EUROPEAN PATENT APPLICATION

(11) **EP 4 528 789 A1**
(43) Date of publication of application: **26.03.2025**
(21) Application number: 24200577.5
(22) Date of filing: 16.09.2024
(51) Int. Cl.: H01L 21/285, C23C 16/455, H01L 21/768

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 22.09.2023 JP 2023158278
(71) Applicant: Kokusai Electric Corporation, Tokyo 101-0045 (JP)
(72) Inventor: KAGA, Yukinao, Toyama-shi, Toyama 939-2393 (JP); KURIBAYASHI, Koei, Toyama-shi, Toyama 939-2393 (JP); BANNAE, Yuki, Toyama-shi, Toyama 939-2393 (JP)
(74) Representative: Bardehle Pagenberg Partnerschaft mbB Patentanwälte Rechtsanwälte

(57) **Abstract**

There is provided a technique that includes forming a film (500) containing a first element on at least a portion of a substrate (200) having a first surface (300) and a second surface (400), which are made of different substances, by performing a first cycle a first number of times, the first cycle including non-simultaneously performing: (a1) supplying a first gas containing the first element to the substrate (200) to form a substance X containing the first element on the at least a portion of the substrate (200); and (a2) supplying a first reaction gas, which reacts with the substance X, to the substrate (200), wherein an incubation time of the first gas on the second surface (400) is longer than an incubation time of the first gas on the first surface (300), and in (a1), at least a portion of the substance X formed on the substrate (200) is removed.

## Description

### CROSS-REFERENCE TO RELATED APPLICATION

This application is based upon and claims the benefit of priority from Japanese P atent Application No. 2023-158278, filed on September 22, 2023, the entire contents of which are incorporated herein by reference.

### TECHNICAL FIELD

The present disclosure relates to a method of processing a substrate, a method of manufacturing a semiconductor device, a substrate processing apparatus, and a progra m.

### BACKGROUND

In the related art, as a process of manufacturing a semiconductor device or proce sses of processing a substrate, a film may be formed on a certain surface of a substrate p referentially over other surfaces.

### SUMMARY

Some embodiments of the present disclosure provide a technique capable of form ing a film on a certain surface of a substrate preferentially over other surfaces.

According to one embodiment of the present disclosure, there is provided a techn ique that includes: forming a film containing a first element on at least a portion of a sub strate having a first surface and a second surface, which are made of different substance s, by performing a first cycle a first number of times, the first cycle including non-simult aneously performing: (a1) supplying a first gas containing the first element to the substr ate to form a substance X containing the first element on the at least a portion of the sub strate; and (a2) supplying a first reaction gas, which reacts with the substance X, to the s ubstrate, wherein an incubation time of the first gas on the second surface is longer than an incubation time of the first gas on the first surface, and in (a1), at least a portion of th e substance X formed on the substrate is removed.

### BRIEF DESCRIPTION OF DRAWINGS

The accompanying drawings, which are incorporated in and constitute a part of t he specification, illustrate embodiments of the present disclosure.
FIG. 1 is a longitudinal sectional view showing the outline of a vertical process fur nace of a substrate processing apparatus according to one embodiment of the present di sclosure.
FIG. 2 is a schematic configuration diagram of a controller of the substrate proces sing apparatus according to one embodiment of the present disclosure, in which a contr ol system of the controller is shown in a block diagram.
FIG. 3 is a diagram showing a substrate processing process according to one emb odiment of the present disclosure.
FIG. 4A is a diagram showing a state in which a first gas is supplied to a substrate having a first surface and a second surface.
FIG. 4B is a diagram showing a state in which a substance containing a first elem ent is formed on the first surface and the second surface.
FIG. 4C is a diagram showing a state in which the first gas removes the substance containing the first element formed on the substrate when the first gas is supplied to the substrate of FIG. 4B.
FIG. 4D is a diagram showing a state on the substrate after at least a portion of th e substance containing the first element is removed.
FIG. 5 is an image diagram for explaining a film formed on a substrate by the sub strate processing process according to one embodiment of the present disclosure.
FIG. 6 is a diagram showing a substrate processing process according to a second embodiment of the present disclosure.

### DETAILED DESCRIPTION

Reference will now be made in detail to various embodiments, examples of which are illustrated in the accompanying drawings. In the following detailed description, nu merous specific details are set forth in order to provide a thorough understanding of the present disclosure. However, it will be apparent to one of ordinary skill in the art that th e present disclosure may be practiced without these specific details. In other instances, well-known methods, procedures, systems, and components have not been described in detail so as not to unnecessarily obscure aspects of the various embodiments.

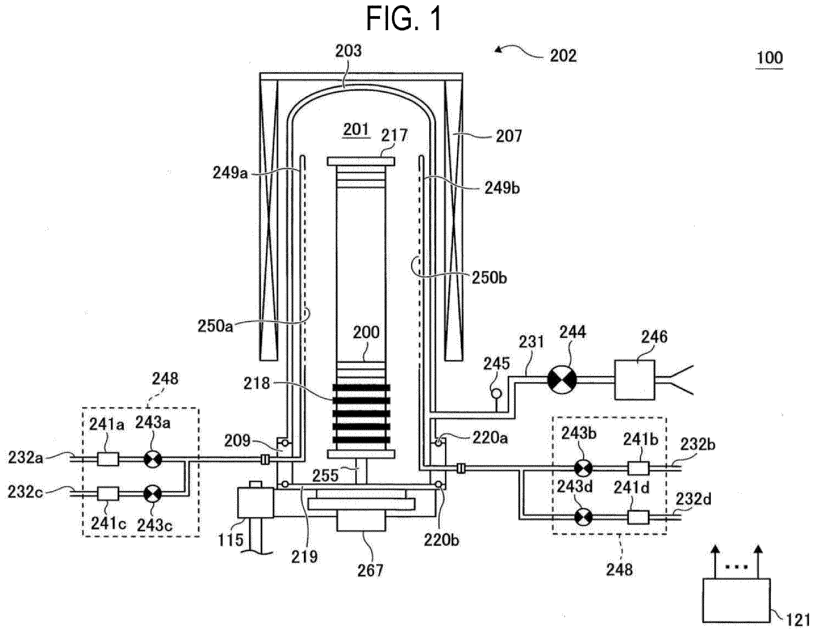

Hereinafter, one embodiment of the present disclosure will be described mainly with reference to FIGS. 1 to 5. In addition, it should be noted that the drawings are sche matic, and the relationships between dimensions of respective elements, the ratios of th e respective elements, and the like may differ from reality. Also, there may be a case wh ere the relationship of dimensions and the ratios differ from each other between the dra wings.

### (1) Configuration of Substrate Processing Apparatus

As shown in FIG. 1, a process furnace 202 includes a heater 207 as a heating syste m (a temperature adjustor). The heater 207 also functions as an activation mechanism ( an excitation part) that thermally activates (excites) a gas.

A reaction tube 203 is disposed inside the heater 207. The reaction tube 203 is m ade of, for example, a heat resistant material such as quartz (SiO₂) or silicon carbide (Si C), and has a cylindrical shape with its upper end closed and its lower end open. A mani fold 209 that supports the reaction tube 203 is disposed under the reaction tube 203. A n O-ring 220a serving as a seal member is provided between the manifold 209 and the r eaction tube 203. A process container (reaction container) is mainly constituted with th e reaction tube 203 and the manifold 209. A process chamber 201 capable of accommo dating one or more wafers 200 as substrates is formed inside the process container.

Nozzles 249a and 249b are provided inside the process chamber 201 so as to pen etrate through a sidewall of the manifold 209. Gas supply pipes 232a and 232b are conn ected to the nozzles 249a and 249b, respectively.

Mass flow controllers (MFCs) 241a and 241b, which are flow rate controllers (flo w rate control parts), and valves 243a and 243b, which are opening/closing valves, are p rovided in the gas supply pipes 232a and 232b, respectively, sequentially from the upstr eam side. Gas supply pipes 232c and 232d are connected to the gas supply pipes 232a a nd 232b at the downstream side of the valves 243a and 243b, respectively. MFCs 241c a nd 241d and valves 243c and 243d are provided in the gas supply pipes 232c and 232d, r espectively, sequentially from the upstream side.

Each of the nozzles 249a and 249b is provided in an annular space (in a plan view ) between an inner wall of the reaction tube 203 and the wafers 200 so as to extend upw ard from a lower portion of the inner wall of the reaction tube 203 to an upper portion t hereof along an arrangement direction of the wafers 200. Gas supply holes 250a and 25 ob for supplying a gas are provided on sides of the nozzles 249a and 249b, respectively. The gas supply holes 250a and 250b are each open so as to face the center of the reactio n tube 203, so that a gas may be supplied toward the wafers 200. A plurality of gas supp ly holes 250a and 250b are provided from the lower portion of the reaction tube 203 to t he upper portion thereof.

A first gas containing a first element is supplied from the gas supply pipe 232a int o the process chamber 201 via the MFC 241a, the valve 243a, and the nozzle 249a.

A first reaction gas that reacts with a substance containing the first element is sup plied from the gas supply pipe 232b into the process chamber 201 via the MFC 241b, the valve 243b, and the nozzle 249b.

An inert gas is supplied from the gas supply pipes 232c and 232d into the process chamber 201 via the MFCs 241c and 241d, the valves 243c and 243d, the gas supply pipe s 232a and 232b, and the nozzles 249a and 249b, respectively.

A first gas supply system mainly includes the gas supply pipe 232a, the MFC 241a , and the valve 243a. A first reaction gas supply system mainly includes the gas supply p ipe 232b, the MFC 241b, and the valve 243b. The first gas supply system and the first re action gas supply system may be collectively referred to as a gas supply system. Further, an inert gas supply system mainly includes the gas supply pipes 232c and 232d, the MF Cs 241c and 241d, and the valves 243c and 243d. The inert gas supply system may be in cluded in the gas supply system.

One or all of the above-described various supply systems may be configured as an integrated-type supply system 248 in which the valves 243a to 243d, the MFCs 241a to 2 41d, and the like are integrated. The integrated-type supply system 248 is connected to each of the gas supply pipes 232a to 232d and is configured such that operations of supp lying various kinds of gases into the gas supply pipes 232a to 232d, that is, the opening/ closing operation of the valves 243a to 243d, the flow rate adjustment operation by the MFCs 241a to 241d, and the like, are controlled by a controller 121 which will be describe d later.

An exhaust pipe 231 for exhausting an internal atmosphere of the process chamb er 201 is provided in the reaction tube 203. A vacuum pump 246 as a vacuum exhaust d evice is connected to the exhaust pipe 231 via a pressure sensor 245 as a pressure detect or (pressure detection part) for detecting an internal pressure of the process chamber 20 1 and an APC (Auto Pressure Controller) valve 244 as a pressure regulator (pressure adj ustment part). The APC valve 244 is configured to perform or stop a vacuum exhausting operation in the process chamber 201 by opening/closing the valve while the vacuum pu mp 246 is actuated. The APC valve 244 is also configured to adjust the internal pressure of the process chamber 201 by adjusting an opening degree of the valve based on pressu re information detected by the pressure sensor 245 while the vacuum pump 246 is actua ted. An exhaust system mainly includes the exhaust pipe 231, the APC valve 244, and th e pressure sensor 245. The vacuum pump 246 may be included in the exhaust system.

A seal cap 219 as a furnace opening cover capable of hermetically sealing a lower end opening of the manifold 209 is provided under the manifold 209. An O-ring 220b a s a seal member making contact with the lower end of the manifold 209 is provided on a n upper surface of the seal cap 219. A rotation mechanism 267 that rotates a boat 217, w hich will be described later, is installed under the seal cap 219. A rotary shaft 255 of the rotation mechanism 267 is connected to the boat 217 via the seal cap 219. The boat elev ator 115 is configured to be able to load/unload the boat 217 into/out of the process cha mber 201 by raising and lowering the seal cap 219. The boat elevator 115 is configured a s a transfer device (transfer mechanism) which transfers the boat 217, that is, the wafers 200, into/out of the process chamber 201.

The boat 217 as a substrate support is configured to support a plurality of wafers 200, for example, 25 to 200 wafers, in such a state that the wafers 200 are arranged in a horizontal posture and in multiple stages along a vertical direction with centers of the w afers 200 aligned with one another. That is, the boat 217 is configured to arrange the wa fers 200 to be spaced apart from each other. The boat 217 is made of, for example, a hea t resistant material such as quartz or SiC. Heat insulating plates 218 made of, for examp le, a heat resistant material such as quartz or SiC are installed below the boat 217 in mul tiple stages. Here, the notation of a numerical range such as "25 to 200 wafers" in the p resent disclosure means that the lower limit value and the upper limit value are included in the range. Therefore, for example, "25 to 200 wafers" means "25 or more wafers and 200 or fewer wafers". The same applies to other numerical ranges.

A temperature sensor 263 as a temperature detector is installed inside the reactio n tube 203. Based on temperature information detected by the temperature sensor 263, a state of supplying electric power to the heater 207 is adjusted such that an interior of t he process chamber 201 has a desired temperature distribution. The temperature senso r 263 is configured in an L-shape and is provided along the inner wall of the reaction tub e 203.

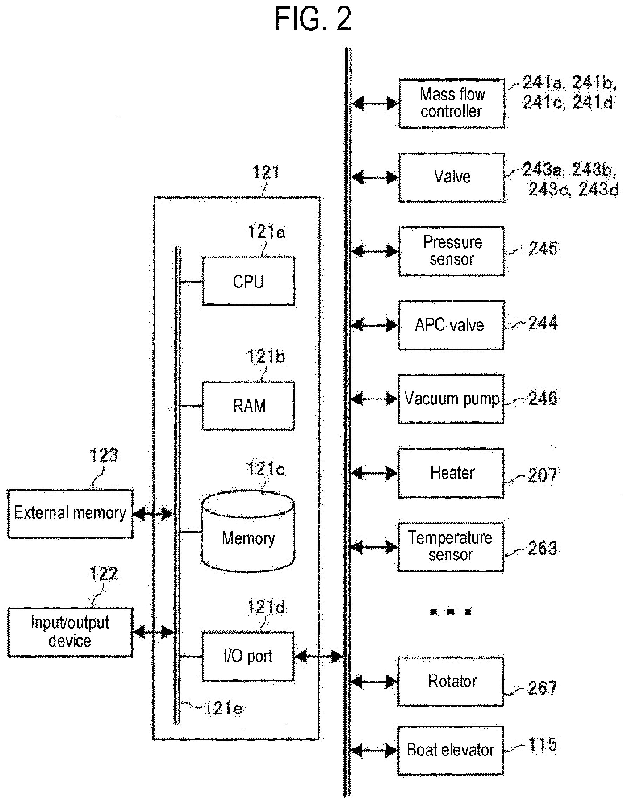

As shown in FIG. 2, the controller 121, which is a control part (control means), is configured as a computer including a central processing unit (CPU) 121a, a random acce ss memory (RAM) 121b, a memory 121c, and an I/O port 121d. The RAM 121b, the mem ory 121c, and the I/O port 121d are configured to be capable of exchanging data with the CPU 121a via an internal bus 121e. An input/output device 122 including, e.g., a touch p anel or the like, is connected to the controller 121. Further, the substrate processing app aratus may be configured to include one control part, or may be configured to include a plurality of control parts. That is, control for performing a substrate processing process to be described later may be performed using one control part, or may be performed usi ng a plurality of control parts. Further, the plurality of control parts may be configured as a control system in which the plurality of control parts are connected to each other vi a a wired or wireless communication network, and the entire control system may perfor m control for performing the substrate processing process to be described later. When t he term "control part" is used in the present disclosure, it may include not only one cont rol part but also a plurality of control parts or a control system configured by a plurality of control parts.

The memory 121C is configured by, for example, a flash memory, a hard disk drive (HDD), or the like. A control program for controlling operations of the substrate proces sing apparatus 100, a process recipe in which sequences and conditions of substrate pro cessing to be described later are written, and the like, are readably stored in the memory 121c. The process recipe functions as a program that causes the controller 121 to execute each sequence in the substrate processing, which will be described later, to obtain an ex pected result. Hereinafter, the process recipe and the control program may be generally and simply referred to as a "program." Further, the process recipe may be simply referr ed to as a "recipe". When the term "program" is used herein, it may indicate a case of in cluding the recipe alone, a case of including the control program alone, or a case of inclu ding both the recipe and the control program. The RAM 121b is configured as a memory area (work area) in which programs or data read by the CPU 121a are temporarily stored

The I/O port 121d is connected to the MFCs 241a to 241d, the valves 243a to 243d , the pressure sensor 245, the APC valve 244, the vacuum pump 246, the heater 207, the temperature sensor 263, the rotation mechanism 267, the boat elevator 115, and the like.

The CPU 121a is configured to read and execute the control program from the me mory 121c. The CPU 121a is also configured to read the recipe from the memory 121c acc ording to an input of an operation command from the input/output device 122. The CP U 121a is configured to control the flow rate adjusting operation of various kinds of gase s by the MFCs 241a to 241d, the opening/closing operation of the valves 243a to 243d, t he opening/closing operation of the APC valve 244, the pressure adjusting operation per formed by the APC valve 244 based on the pressure sensor 245, the actuating and stoppi ng operation of the vacuum pump 246, the temperature adjusting operation performed by the heater 207 based on the temperature sensor 263, the operation of rotating the bo at 217 with the rotation mechanism 267 and adjusting the rotation speed of the boat 217, the operation of moving the boat 217 up and down by the boat elevator 115, and the like, according to contents of the read recipe.

The controller 121 may be configured by installing, on the computer, the aforeme ntioned program stored in an external memory (for example, a magnetic disk such as a hard disk, an optical disc such as a CD, a magneto-optical disc such as a MO, or a semico nductor memory such as a USB memory) 123. The memory 121c or the external memor y 123 is configured as a non-transitory computer-readable recording medium recording a program. Hereinafter, the memory 121c and the external memory 123 may be generall y and simply referred to as a "recording medium". When the term "recording medium" i s used herein, it may indicate a case of including the memory 121c alone, a case of includ ing the external memory 123 alone, or a case of including both the memory 121c and the external memory 123. Further, the program may be provided to the computer using co mmunication means such as the Internet or a dedicated line, instead of using the extern al memory 123.

### (2) Substrate Processing Process

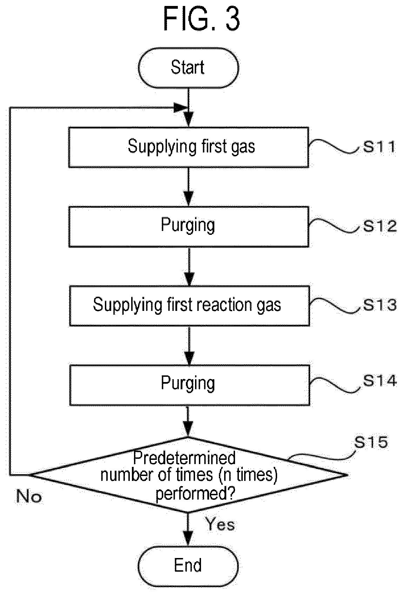

As a process of manufacturing a semiconductor device using the above-described substrate processing apparatus 100, an example of a processing sequence for forming a predetermined film on a first surface 300 of a wafer 200 having the first surface 300 an d a second surface 400, which are made of different substances, will be described with r eference to FIGS. 3 to 5. In the following description, the operations of the respective pa rts constituting the substrate processing apparatus 100 are controlled by the controller 1 21.

The different substances are exposed on the first surface 300 and the second surf ace 400. Specifically, the first surface 300 is a so-called conductive film which is made 0 f a conductive substance and has high electrical conductivity. The first surface 300 is, fo r example, a molybdenum (Mo) film, a titanium nitride (TiN) film or the like. The secon d surface 400 is a film which is made of a non-conductive substance and has lower elect rical conductivity than the first surface. The second surface 400 is, for example, an oxid e film such as a silicon oxide (SiO) film, or a semiconductor film. In this embodiment, a film 500 made of a conductive substance is selectively formed on the first surface 300 of the wafer 200 having the first surface 300 and the second surface 400.

When the term "wafer" is used in the present disclosure, it may refer to "a wafer i tself" or "a wafer and a stacked body of certain layers or films formed on a surface of the wafer." When the phrase "a surface of a wafer" is used in the present disclosure, it may r efer to "a surface of a wafer itself" or "a surface of a certain layer formed on a wafer." W hen the expression "a certain layer is formed on a wafer" is used in the present disclosur e, it may mean that "a certain layer is formed directly on a surface of a wafer itself" or th at "a certain layer is formed on a layer formed on a wafer." When the term "substrate" is used in the present disclosure, it may be synonymous with the term "wafer."

### (Wafer Loading)

When the boat 217 is charged with a plurality of wafers 200 (in a wafer charging o peration), as shown in FIG. 1, the boat 217 supported the plurality of wafers 200 is lifted up by the boat elevator 115 to be loaded into the process chamber 201 (in a boat loading operation) and accommodated in the process container. In this state, the seal cap 219 se als the lower end opening of the manifold 209 via the O-ring 220b.

### (Pressure Adjustment and Temperature Adjustment)

The interior of the process chamber 201, that is, a space where the wafers 200 are placed, is vacuum-exhausted by the vacuum pump 246 to reach a desired pressure (degr ee of vacuum). At this time, the internal pressure of the process chamber 201 is measur ed by the pressure sensor 245, and the APC valve 244 is feedback-controlled based on th e measured pressure information (in a pressure adjustment operation). The vacuum pu mp 246 is kept in a constantly operating state at least until the processing on the wafers 200 is completed. Further, the interior of the process chamber 201 are heated by the he ater 207 so as to have a desired temperature. At this time, the state of supplying electric power to the heater 207 is feedback-controlled based on the temperature information de tected by the temperature sensor 263 so that the interior of the process chamber 201 has a desired temperature distribution (in a temperature adjustment operation). The heatin g of the interior of the process chamber 201 by the heater 207 are continuously perform ed at least until the processing on the wafers 200 is completed.

### (Supply of First Gas, Step S11)

First, a first gas containing a first element is supplied to a wafer 200 in the proces s chamber 201. Specifically, the valve 243a is open to allow the first gas to flow into the gas supply pipe 232a. A flow rate of the first gas is adjusted by the MFC 241a, and the fir st gas is supplied into the process chamber 201 via the nozzle 249a and is exhausted via the exhaust pipe 231. At the same time, the valve 243c is open to allow an inert gas to fl ow into the gas supply pipe 232c. With its flow rate adjusted by the MFC 241c, the inert gas is supplied into the process chamber 201 together with the first gas and is exhausted via the exhaust pipe 231. Further, in order to prevent the first gas from entering the noz zle 249b, the valve 243d is open to allow an inert gas to flow into the gas supply pipe 232 d. The inert gas is supplied into the process chamber 201 via the gas supply pipe 232d a nd the nozzle 249b, and is exhausted from the exhaust pipe 231. At this time, a main ga s flowing into the process chamber 201 is the first gas containing the first element.

Process conditions in Step S11 are exemplified as follows:
Temperature of the wafer 200: 300 to 700 degrees C
Supply time of the first gas: 1 to 60 seconds
Partial pressure of the first gas: 10 to 10,000Pa

By supplying the first gas, a substance X containing the first element is formed on at least a portion of the wafer 200. Here, the substance X is a molecule of the first gas c hemically or physically adsorbed on the surface of the wafer 200 and/or a portion of the molecular structure of the first gas, and is at least one of a substance containing the first element, a compound containing the first element chemically bonded with other elemen ts, or a simple substance of the reduced first element. Specifically, when a metal-contai ning gas is used as the first gas, the substance X is a molecule of the metal-containing ga s and/or a portion of the molecular structure of the metal-containing gas, and is at least one of a substance containing a metal element, a compound containing a metal element chemically bonded with other elements, or a simple substance of the reduced metal ele ment. More specifically, for example, the substance X is a molecule of a Mo-containing gas, a portion of the molecular structure of the Mo-containing gas, Mo or the like.

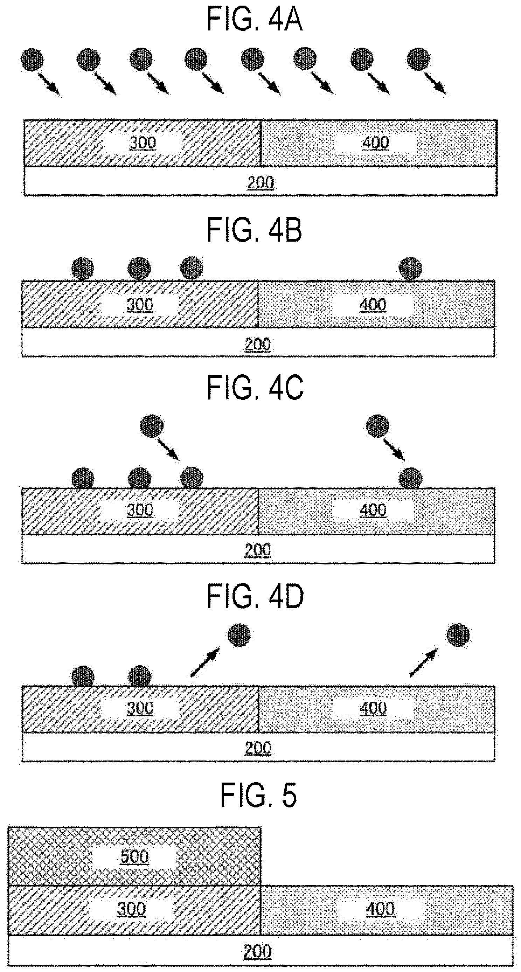

FIGS. 4A to 4D are image diagrams for explaining the state on the wafer 200 in t his step.

Here, in this embodiment, an incubation time of the first gas on the second surfac e 400 is set to be longer than that of the first gas on the first surface 300. Therefore, the amount of substance X containing the first element formed on the first surface 300 is lar ger than the amount of substance X containing the first element formed on the second s urface 400. Here, the incubation time refers to the time it takes from the start of the su pply of a gas to a surface until gas molecules begin to adsorb or a film begins to form on the surface.

That is, the time it takes for the molecules of the first gas to begin to adsorb on th e second surface 400 is longer than that of the first surface 300. For this reason, as sho wn in FIG. 4A, even if the first gas is supplied onto the wafer 200 having the first surface 300 and the second surface 400, the substance X is less likely to be formed on the secon d surface 400 than on the first surface 300.

However, for example, even if the supply time of the first gas in this step is set to a time equal to or shorter than the incubation time of the first gas on the second surface 400, as shown in FIG. 4B, the substance X containing the first element may be formed o n a portion of the second surface 400, which causes a selective rapture. Then, with each processing cycle, the substance X containing the first element may grow around the sele ctive rapture, and the substance X may be formed on the second surface 400 as well.

Here, the first gas has the property of removing the substance X. As a result, in t his step, the substance X containing the first element is formed, and at the same time, th e substance X containing the first element formed on the wafer 200 as shown in FIGS. 4 C and 4D is removed.

In this embodiment, on the first surface 300, the amount of substance X formed per unit time is set to exceed the amount of substance X removed per unit time. Further , on the second surface 400, the amount of substance X formed per unit time is set to be below the amount of substance X removed per unit time. As a result, in this step, as sho wn in FIG. 4D, it is possible to make it easier for the substance X to be formed on the fir st surface 300 and harder for the substance X to be formed on the second surface 400.

As described above, in this step, due to a difference in incubation time between th e first surface 300 and the second surface 400 of the first gas and the removal of the sub stance X containing the first element, the substance X containing the first element is for med on the first surface 300 preferentially over the second surface 400.

In other words, it may be said that the first gas has the effect of forming the subst ance X containing the first element on the first surface 300 while etching the substance X. That is, in the technique disclosed herein, the first gas may form the substance X on t he first surface 300 while etching the substance X on the second surface 400. As a resul t, even if the selective rapture is not removed by an additional process such as etching th e substance X, the substance X containing the first element may be selectively formed o n the first surface 300.

Further, this step may be performed under a condition in which the substance X c ontaining the first element may be formed on at least a portion of the second surface 40 0. As a result, the selective rapture becomes more likely to be formed on the second surf ace 400, but the amount of substance X containing the first element formed on the first surface 300 per unit time may be increased. Further, even in such a case, the selective r apture on the second surface 400 is removed by removing the substance X containing th e first element in this step. Therefore, by performing this step under the condition in wh ich the substance X containing the first element may be formed on at least a portion of t he second surface 400, it is possible to obtain good selectivity while increasing the amou nt of substance X formed on the first surface 300 per unit time.

According to the verification conducted by the present disclosers, it has been conf irmed that in this step, the substance X containing the first element formed on the secon d surface 400 is removed preferentially over the second surface 400 (i.e., the non-condu ctive substance). In other words, the etching rate of the non-conductive substance by th e first gas is lower than the etching rate of the conductive substance. This makes it possi ble to remove the selective rapture of the substance X on the second surface 400 without damaging the non-conductive substance that constitutes the second surface 400.

As the first gas, a gas containing a metal element as the first element and a haloge n element may be used.

As the metal element, for example, a metal element of Periods 4 to 6 and Groups III to XIV may be used. Preferably, as the metal element, a transition metal element of Groups III to XII may be used. In this case, the effects of this embodiment may be more effectively obtained. More preferably, as the metal element, a transition metal element of Period 5 may be used. In this case, the effects of this embodiment may be further obt ained. As the transition metal element of Period 5, for example, Mo or the like may be u sed. In this case, the effects of this embodiment may be particularly easily obtained.

As the halogen element, for example, chlorine (Cl), fluorine (F), bromine (Br), iod ine (I) or the like may be used. One or more of these elements may be used as the halog en element.

Specifically, as the first gas, for example, a gas containing Mo and Cl may be used . In this case, the effects of this embodiment may be particularly easily obtained. As the gas containing Mo and Cl, for example, a gas including one of a molybdenum dichloride dioxide (MoO₂Cl₂) gas, a molybdenum tetrachloride oxide (MoOCl₄) gas, a molybdenum pentachloride (MoCl₅) gas, a molybdenum tetrachloride (MoCl₄) gas or the like, or a gas including one or more of these gases may be used.

Further, when a gas containing the transition metal element of Period 5, which ha s an electron orbit similar to that of Mo, and Cl is used as the first gas, it is easy to obtain the same effects as when the gas containing Mo and Cl is used. Examples of the transiti on metal element of Period 5 may include yttrium (Y), zirconium (Zr), niobium (Nb), tec hnetium (Tc), ruthenium (Ru), rhodium (Rh), palladium (Pd), silver (Ag), cadmium (Cd ) or the like.

As the inert gas, for example, a nitrogen (N₂) gas, and noble gases such as an argo n (Ar) gas, a helium (He) gas, a neon (Ne) gas, and a xenon (Xe) gas may be used. One o r more of these gases may be used as the inert gas.

### (Purging, Step S₁₂)

After the substance X containing the first element is formed on at least a portion of the wafer 200, with the valves 243a and 243b closed, the valves 243c and 243d are op en to allow an inert gas as a purge gas to be supplied into the gas supply pipes 232a and 232b via the gas supply pipes 232c and 232d. At the same time, with the APC valve 244 of the exhaust pipe 231 left open, the interior of the process chamber 201 is vacuum-exh austed by the vacuum pump 246 to purge the interior of the process chamber 201.

### (Supply of First Reaction Gas, Step S13)

Subsequently, a first reaction gas is supplied to the wafer 200 inside the process c hamber 201. Specifically, the valve 243b is open to allow the first reaction gas to flow in to the gas supply pipe 232b. A flow rate of the first reaction gas is adjusted by the MFC 241b, and the first reaction gas is supplied into the process chamber 201 via the nozzle 2 49b and is exhausted via the exhaust pipe 231. At the same time, the valve 243d is open to allow an inert gas to flow into the gas supply pipe 232d. With its flow rate adjusted by the MFC 241d, the inert gas is supplied into the process chamber 201 together with the f irst reaction gas, and is exhausted via the exhaust pipe 231. Further, in order to prevent the first reaction gas from entering the nozzle 249a, the valve 243c is open to allow an in ert gas to flow into the gas supply pipe 232c. The inert gas is supplied into the process c hamber 201 via the gas supply pipe 232c and the nozzle 249a, and is exhausted via the e xhaust pipe 231. At this time, a main gas flowing into the process chamber 201 is the fir st reaction gas.

Process conditions in Step S13 are exemplified as follows:
Temperature of the wafer 200: 300 to 700 degrees C
Supply time of the first reaction gas: 0.01 to 600 seconds
Partial pressure of the first reaction gas: 4,000 to 13,000Pa

As the first reaction gas, for example, a gas that reacts with the substance X conta ining the first element and has reducing properties relative to the first gas may be used. As the first reaction gas, for example, a hydrogen (H₂) gas, a deuterium (D₂) gas, a boran e (BH₃) gas, a diborane (B₂H₆) gas, a carbon monoxide (CO) gas, an ammonia (NH₃) gas , a monosilane (SiH₄) gas, a disilane (Si₂H₆) gas, a trisilane (Si₃H₈) gas, a monogermane (GeH₄) gas, a digermane (Ge₂H₆) gas or the like may be used.

Further, as the first reaction gas, in addition to a reducing gas, a gas that reacts w ith the substance X to form a conductive substance, such as a nitriding gas, a sulfide gas, a selenide gas, a telluride gas or the like. For example, when the first reaction gas is any one of the nitriding gas, the sulfide gas, the selenide gas, and the telluride gas, a nitridin g film, a sulfide film, a selenide film, or a telluride film may be formed on the wafer.

As the nitriding gas, for example, one or more of hydrogen nitride gases such as a n NH₃ gas, a diazene (N₂H₂) gas, and a hydrazine (N₂H₄) gas may be used. As the sulfid e gas, for example, gases including sulfane (H₂S), disulfane (H₂S₂), diammonium sulfide ((NH₄)₂S), dimethyl sulfide ((CH₃)₂S) or the like may be used. As the sulfide gas, one or more of these gases may be used. As the selenide gas, for example, gases containing sele nium (H₂Se), diselane (H₂Se₂), dimethyl selenium ((CH₃)₂Se) or the like may be used. A s the selenide gas, one or more of these gases may be used. As the telluride gas, for exa mple, gases containing terane (H₂Te), diterane (H₂Te₂), dimethyl terane ((CH₃)₂Te) or t he like may be used. As the telluride gas, one or more of these gases may be used.

### (Purging, Step S14)

After a layer containing the first element constituted with the substance X is form ed on the wafer 200, an inert gas as a purge gas is supplied according to the same proces sing procedure as in the above-described Step S12, and with the APC valve 244 of the ex haust pipe 231 left open, the interior of the process chamber 201 is vacuum-exhausted b y the vacuum pump 246 to purge the interior of the process chamber 201.

### (Performing Cycle Predetermined Number of Times, Step S15)

A first cycle in which the above-described Steps S11 to S14 is non-simultaneously performed is performed a first number of times (n, where n is an integer of 1 or 2 or mor e). The first cycle is performed, for example, 1 to 200 times. As a result, as shown in FI G. 5, a film 500, which is at least a portion on the wafer 200, having a predetermined thi ckness and containing the first element, is formed on the first surface 300 on the wafer 200 having the first surface 300 and the second surface 400.

The film 500 containing the first element is a film made of a conductive substanc e. As the film made of the conductive substance, for example, a metal-containing film co ntaining a metal element or the like is formed. As the metal-containing film, for exampl e, a Mo-containing film or the like is formed.

Here, when the supply of the first gas supply and the supply of the first reaction g as as described above are performed simultaneously, the substance X containing the firs t element is formed on the wafer 200 by a reaction between the first gas and the first rea ction gas in a gas phase. In this case, the gas is easily consumed by the reaction between the first gas and the first reaction gas at places on the wafer surface where the gas may e asily reach, while the first gas and the first reaction gas are not sufficiently supplied to pl aces where the gas cannot easily reach. Therefore, the thickness of the film formed on t he wafer surface is likely to differ.

In this embodiment, by non-simultaneously supplying the first gas and the first r eaction gas, after a sufficient amount of first gas reaches the places where the gas cannot easily reach, the reaction with the first reaction gas may occur. Therefore, the uniformit y of the film thickness on the wafer surface may be improved.

When, for example, a MoCl₅ gas is used as the first gas and, for example, a H₂ gas is used as the first reaction gas, the MoCl₅ gas and the H₂ gas react with each other, ther eby reducing Cl in the MoCl₅ gas by the H₂ gas. As a result, a molybdenum (Mo)-contai ning film, which is a metal-containing film, is formed as the substance X on the first surf ace 300 on the wafer 200. At this time, reaction by-products such as hydrogen chloride (HCl) and Cl₂ are generated. By performing the purging operation between the supply 0 f the first gas and the supply of the first reaction gas, a gas and reaction by-products rem aining in the process chamber 201 are removed.

### (After-Purging and Returning to Atmospheric Pressure)

An inert gas is supplied into the process chamber 201 from each of the gas supply pipes 232c and 232d and is exhausted via the exhaust pipe 231. The inert gas acts as a p urge gas. As a result, the interior of the process chamber 201 is purged to remove the ga s and reaction by-products remaining in the process chamber 201 are removed from the process chamber 201 (in an after-purging operation). After that, the internal atmospher e of the process chamber 201 is substituted with an inert gas (in an inert gas substitution operation) and the internal pressure of the process chamber 201 is returned to the atmo spheric pressure (in an atmospheric pressure returning operation).

### (Unloading of Wafer)

The seal cap 219 is moved down by the boat elevator 115 to open the lower end of the manifold 209. Then, the processed wafers 200 supported by the boat 217 are unload ed from the lower end of the manifold 209 to the outside of the reaction tube 203 (in a b oat unloading operation). The processed wafers 200 are discharged from the boat 217 (i n a wafer discharging operation).

### (3) Other Embodiments

Next, other embodiments of the substrate processing process and the substrate p rocessing apparatus in the above-described embodiment will be described in detail. In t he following embodiments, only differences from the above-described embodiment will be described in detail.

### (Second Embodiment)

In this embodiment, for example, a second gas supply system and a second reacti on gas supply system are added to the above-described substrate processing apparatus 1 00. Specifically, for example, a second gas supply pipe 232e for supplying a second gas i s connected to the downstream side of the valve 243a of the gas supply pipe 232a and th e upstream side of a connection portion with the gas supply pipe 232c. Further, a secon d reaction gas supply pipe 232f for supplying a second reaction gas is connected to the d ownstream side of the valve 243b of the gas supply pipe 232b and the upstream side of a connection portion with the gas supply pipe 232d. The gas supply pipes 232e and 232f a re provided with MFCs 241e and 241f and valves 243e and 243f, respectively, sequentiall y from the upstream side. The second gas supply system includes the gas supply pipe 23 2e, the MFC 241e, and the valve 243e. The second reaction gas supply system includes t he gas supply pipe 232f, the MFC 241f, and the valve 243f.

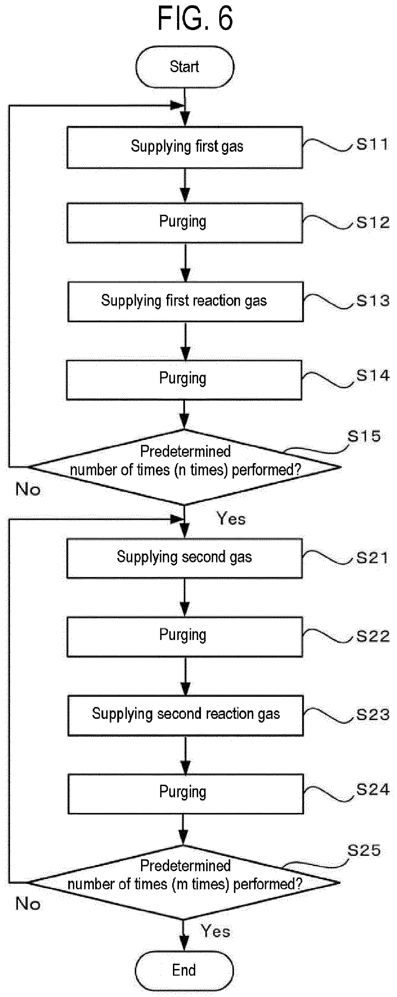

In this embodiment, as shown in FIG. 6, after the first cycle in which the above-d escribed Steps S11 to S15 are non-simultaneously performed is performed n times, a sec ond cycle in which Steps S21 to S25 are non-simultaneously performed is performed m t imes. That is, the second cycle with different conditions from the first cycle is further pe rformed. In this way, by selectively forming a film containing the first element on the fir st surface 300 of the wafer 200, the selectivity and the film formation rate may be optim ized.

### (Supply of Second Gas, Step S21)

After the above-described Steps S11 to S15 are performed to form the film contain ing the first element on at least a portion of the wafer 200, a second gas containing the fi rst element is supplied to the wafer 200 in the process chamber 201. Specifically, the va lve 243e is open to allow the second gas to flow into the gas supply pipe 232e. A flow rat e of the second gas is adjusted by the MFC 241e, and the second gas is supplied into the process chamber 201 via the nozzle 249a and is exhausted via the exhaust pipe 231. At t he same time, the valve 243c is open to allow an inert gas to flow into the gas supply pip e 232c. With its flow rate adjusted by the MFC 241c, the inert gas is supplied into the pr ocess chamber 201 together with the second gas and is exhausted via the exhaust pipe 2 31. Further, in order to prevent the second gas from entering the nozzle 249b, the valve 243d is open to allow an inert gas to flow into the gas supply pipe 232d. The inert gas is supplied into the process chamber 201 via the gas supply pipe 232d and the nozzle 249b and is exhausted via the exhaust pipe 231.

A main gas flowing into the process chamber 201 at this time is the second gas co ntaining the first element. As the second gas, for example, a gas containing a metal elem ent as the first element and a halogen element may be used. As the second gas, one or m ore of the gases exemplified as the first gas may be used.

Here, in this embodiment, the "substance X containing one element" used in the above-described embodiment further includes "among the molecules of the second gas c hemically or physically adsorbed on the surface of the wafer 200 and/or portions of the molecular structure of the second gas, at least one of a substance containing the first ele ment, a compound containing the first element chemically bonded with other elements, or a simple substance of the reduced first element". In Step S21, the substance X contai ning the first element is formed on at least a portion of the wafer 200 by supplying the s econd gas.

Here, an incubation time of the second gas on the first surface 300 and an incuba tion time of the second gas on the second surface 400 may be different from each other. For example, the incubation time of the second gas on the second surface 400 may be lo nger than that that on the first surface 300. As a result, a film may be selectively formed on the first surface 300 with respect to the second surface 400 even in the second cycle, thereby improving selectivity.

Further, in Step S21, at least a portion of the substance X formed on the wafer 20 0 may be removed. Further, the ease of removal of the substance X may be different bet ween Step S11 and Step S21. Hereinafter, an example will be described in which Step S2 1 is performed under conditions in which the substance X is more easily removed than i n Step S11 (in other words, the second cycle is performed under conditions in which the substance X is more easily removed than in the first cycle).

As an example of the conditions in which the substance X formed on the wafer 20 0 is more easily removed in Step S21 than in Step S11, a gas having a higher reactivity wi th the substance X containing the first element formed on the wafer 200 than the first g as may be used as the second gas. That is, by using a gas, which is different from the firs t gas, as the second gas, the ease of removal of the substance X containing the first elem ent may be changed in the first cycle using the first gas and the second cycle using the se cond gas.

As the second gas having the higher reactivity with the substance X containing th e first element than the first gas, for example, a gas containing a larger number of haloge n elements in one molecule than the above-described first gas may be used. When a Mo O₂Cl₂ gas is used as the first gas, for example, a MoCl₅ gas may be used as the second gas

Process conditions in Step S11 when the MoO₂Cl₂ gas is used as the first gas are e xemplified as follows:
Temperature of the wafer 200: 300 to 700 degrees C
Supply time of the first gas: 1 to 60 seconds
Partial pressure of the first gas: 10 to 10,000Pa
First number of times: 1 to 200 times

Process conditions in Step S21 when the MoCl₅ gas is used as the second gas are e xemplified as follows:
Temperature of the wafer 200: 300 to 700 degrees C
Supply time of the second gas: 1 to 60 seconds
Partial pressure of the second gas: 10 to 10,000Pa
Second number of times: 1 to 50 times

As an example of conditions in which the substance X formed on the wafer 200 is more easily removed in Step S21 than in Step S11, the partial pressure of the second gas i n the process chamber 201 (in the space in which the wafer 200 is placed) in Step S21 m ay be made higher than the partial pressure of the first gas in the process chamber 201 i n Step S11. In this way, by changing the partial pressures in Steps S11 and S21, the ease of removal of the substance X containing the first element in the first cycle and the seco nd cycle may be changed. In this case, even if the first gas and the second gas have the s ame molecular structure, the ease of removal of the substance X containing the first ele ment in the first cycle and the second cycle may be changed.

When the substance X containing the first element formed on the wafer 200 is re moved, other conductive substances, for example, the conductive substance constituting the first surface 300, may also be removed. As in this embodiment, by performing the fi rst cycle and the second cycle different from each other in the ease of removal of the sub stance containing the first element, damage to other conductive substances may be supp ressed and the selectivity and film formation rate may be optimized.

For example, the first cycle is performed first, and then the second cycle is perfor med. In this case, since the substance X containing the first element is relatively difficul t to be removed in the first cycle, the substance X containing the first element may be for med on the first surface 300 while suppressing damage to the conductive substance (etc hing of the conductive substance) constituting the first surface 300. Then, in the second cycle, since the substance X containing the first element has already been formed on the first surface 300, the conductive substance constituting the first surface 300 is difficult t o be removed. That is, damage to conductive substances other than the substance X ma y be suppressed.

Further, among gases containing the first element, there may be some that have a low vapor pressure, although they are likely to form a film with good selectivity because the substance X containing the first element is easily removed. For example, a MoCl₅ ga s is a gas that is easier to form a film with good selectivity but has a lower vapor pressure than a MoO₂Cl₂ gas. When processing the wafer 200 with a large surface area using suc h a gas, it may be difficult to supply a sufficient amount of gas to process the entire surfa ce of the wafer 200. In this embodiment, a gas that is easy to form a film on the wafer 2 00 with good selectivity and has a low vapor pressure, and a gas that has a high vapor pr essure and is difficult to form a film on the wafer 200 with good selectivity are used. As a result, even when the surface area of the wafer 200 is large, a film containing the first element may be formed on the first surface 300 with good selectivity. Further, it is prefe rable to set the conditions of each step so that the consumption of gas that is easy to for m a film on the wafer 200 with good selectivity and has a low vapor pressure is less than the consumption of gas that has a high vapor pressure and is difficult to form a film with good selectivity throughout the entire substrate processing.

### (Purging, Step S22)

After the substance X containing the first element is formed on at least a portion of the wafer 200, an inert gas as a purge gas is supplied according to the same processin g procedure as in the above-described Step S12, and with the APC valve 244 of the exhau st pipe 231 left open, the interior of the process chamber 201 is vacuum-exhausted by th e vacuum pump 246 to purge the interior of the process chamber 201.

### (Supply of Second Reaction Gas, Step S23)

Subsequently, a second reaction gas is supplied to the wafer 200 in the process ch amber 201. Specifically, the valve 243f is open to allow the second reaction gas to flow i nto the gas supply pipe 232f. A flow rate of the second reaction gas is adjusted by the M FC 241f, and the second reaction gas is supplied into the process chamber 201 via the no zzle 249b and is exhausted via the exhaust pipe 231. At the same time, the valve 243d is open to allow an inert gas to flow into the gas supply pipe 232d. With its flow rate adjus ted by the MFC 241d, the inert gas is supplied into the process chamber 201 together wit h the second reaction gas and is exhausted via the exhaust pipe 231. Further, in order to prevent the second reaction gas from entering the nozzle 249a, the valve 243c is open to allow an inert gas to flow into the gas supply pipe 232c. The inert gas is supplied into th e process chamber 201 via the gas supply pipe 232c and the nozzle 249a and is exhauste d via the exhaust pipe 231. At this time, a main gas flowing into the process chamber 20 1 is the second reaction gas.

As the second reaction gas, for example, a gas that reacts with the substance X co ntaining the first element and has reducing properties relative to the second gas may be used. Further, as the second reaction gas, for example, among gases containing a nitridi ng gas, a sulfide gas, a selenide gas, a telluride gas or the like, a gas that reacts with the s ubstance X to form a conductive substance may be used. The second reaction gas may b e one or more of the gases exemplified as the first reaction gas.

### (Purging, Step S24)

After a layer containing the first element is formed on the wafer 200, an inert gas as a purge gas is supplied according to the same processing procedure as in the above-de scribed Step S12, and with the APC valve 244 of the exhaust pipe 231 left open, the interi or of the process chamber 201 is vacuum-exhausted by the vacuum pump 246 to purge t he interior of the process chamber 201.

### (Performing Cycle Predetermined Number of Times, Step S25)

By performing a second cycle in which the above-described Steps S21 to S24 is no n-simultaneously performed is performed a second number of times (m, where m is an i nteger of 1 or 2 or more), a film, which is at least a portion on the wafer 200, having a pr edetermined thickness and containing the first element is formed on the first surface 30 0.

Further, in this embodiment, the same gas as the above-described first gas may b e used as the second gas. Even in this embodiment, the same effects as the above-descri bed embodiment may be obtained. In this embodiment, since it is not necessary to prov ide a gas supply system different from the first gas supply system, as the second gas sup ply system, the device configuration may be simplified.

The second embodiment has been described by taking as an example a case in wh ich the first cycle including Steps S11 to S15 is performed n times, and then the second c ycle including Steps S21 to S25, in which the substance X is more easily removed than in the first cycle, is performed m times. However, the present disclosure is not limited ther eto. For example, the second cycle including Steps S21 to S25, in which the substance X is more easily removed than in the first cycle, may be performed m times, and then the fi rst cycle including Steps S11 to S15 may be performed n times.

In this case, since the substance X is more easily removed in the first cycle, the sel ective rapture on the second surface 400 is more easily removed. Then, in the second cy cle, since the selective rapture is almost absent on the second surface, the selective raptu re is less likely to occur even if the second gas with low etching properties is used. In co ntrast, the substance X is less likely to be removed on the first surface. In other words, t he selectivity and the film formation rate may be improved.

### (Third Embodiment)

In this embodiment, a processing cycle including the first cycle in which Steps S11 to S15 in the above-described second embodiment are performed the first number of tim es (n times, where n is an integer of 1 or 2 or more) and the second cycle in which Steps S21 to S25 in the above-described second embodiment are performed the second numbe r of times (m times, where m is an integer of 1 or 2 or more) is performed, is performed a plurality of times. Further, a N-th (N is an integer of 2 or more) round and subsequent rounds of processing cycles are performed under conditions different from a (N-1)th rou nd and earlier rounds of processing cycles with respect to the ease of removal of the subs tance X containing the first element formed on the wafer 200.

In this way, the (N-1)th round and earlier rounds of processing cycles and the N-t h round and subsequent rounds of processing cycles, which are different from each othe r with respect to the ease of removal of the substance X containing the first element, ma y be combined. As a result, the selectivity and film formation rate may be optimized whi le suppressing damage to other conductive substances.

For example, the N-th round and subsequent rounds of processing cycles may be different from the (N-1)th round and earlier rounds of processing cycles in at least one 0 f the first number of times and the second number of times. Further, for example, the N -th round and subsequent rounds of processing cycles may be different from the (N-1)th round and earlier rounds of processing cycles in at least one of the supply time of the firs t gas in Step S11 and the supply time of the second gas in Step S21. Further, for example , the N-th round and subsequent rounds of processing cycles may be different from the ( N-1)th round and earlier rounds of processing cycles in at least one of the partial pressur e of the first gas in the process chamber 201 in Step S11 and the partial pressure of the se cond gas in the process chamber 201 in Step S21. By performing at least one of these, th e ease of removal of the substance X containing the first element may be changed betwe en the processing cycles.

For example, the substance X containing the first element is more easily removed in the N-th round and subsequent rounds of processing cycles than in the (N-1)th round and earlier rounds of processing cycles. In this case, since the substance X containing th e first element is relatively difficult to be removed in the (N-1)th round and earlier roun ds of processing cycles, the substance X containing the first element may be formed on t he first surface 300 while suppressing damage to other conductive substances. Then, in the N-th round and subsequent rounds of processing cycles, since the substance X conta ining the first element has already been formed on the first surface 300, the conductive substance constituting the first surface 300 is difficult to be removed. That is, a film con taining the first element may be formed with good selectivity while suppressing damage to conductive substances other than the substance X.

Specifically, for example, in order to make it easier to remove the substance X co ntaining the first element in the N-th round and subsequent rounds of processing cycles than in the (N-1)th round and earlier rounds of processing cycles, the supply time of the second gas in the N-th round and subsequent rounds of processing cycles is longer than the supply time of the second gas in the (N-1)th round and earlier rounds of processing c ycles.

Further, in order to make it easier to remove the substance X containing the first element in the N-th round and subsequent rounds of processing cycles than in the (N-1)t h round and earlier rounds of processing cycles, the first number of times in the N-th ro und and subsequent rounds of processing cycles may be made smaller than the first nu mber of times in the (N-1)th round and earlier rounds of processing cycles. Further, the second number of times in the N-th round and subsequent rounds of processing cycles may be made larger than the second number of times in the (N-1)th round and earlier ro unds of processing cycles. Further, the supply time of the first gas in the N-th round an d subsequent rounds of processing cycles may be made shorter than the supply time of t he first gas in the (N-1)th round and earlier rounds of processing cycles. Further, the pa rtial pressure of the first gas in the N-th round and subsequent rounds of processing cycl es may be made smaller than the partial pressure of the first gas in the (N-1)th round an d earlier rounds of processing cycles. Further, the partial pressure of the second gas in t he N-th round and subsequent rounds of processing cycles may be made larger than the partial pressure of the second gas in the (N-1)th round and earlier rounds of processing cycles.

Further, , it is also possible to make it easier to remove the substance containing t he first element in the (N-1)th round and earlier rounds of processing cycles than in the N-th round and subsequent rounds of processing cycles. That is, the substance X contai ning the first element may be more difficult to be removed in the N-th round and subseq uent rounds of processing cycles than in the (N-1)th round and earlier rounds of process ing cycles. In order to make the substance X containing the first element more difficult t o be removed in the N-th round and subsequent rounds of processing cycles than in the (N-1)th round and earlier rounds of processing cycles, the first number of times in the N -th round and subsequent rounds of processing cycles may be made larger than the first number of times in the (N-1)th round and earlier rounds of processing cycles. Further, t he second number of times in the N-th round and subsequent rounds of processing cycle s may be made smaller than the second number of times in the (N-1)th round and earlie r rounds of processing cycles. Further, the supply time of the first gas in the N-th round and subsequent rounds of processing cycles may be made longer than the supply time of the first gas in the (N-1)th round and earlier rounds of processing cycles. Further, the su pply time of the second gas in the N-th round and subsequent rounds of processing cycle s may be made shorter than the supply time of the second gas in the (N-1)th round and e arlier rounds of processing cycles. Further, the partial pressure of the first gas in the N-t h round and subsequent rounds of processing cycles may be made larger than the partial pressure of the first gas in the (N-1)th round and earlier rounds of processing cycles. Fu rther, the partial pressure of the second gas in the N-th round and subsequent rounds of processing cycles may be made smaller than the partial pressure of the second gas in the (N-1)th round and earlier rounds of processing cycles.

In this case, in the (N-1)th round and earlier rounds of processing cycles, since th e substance X is easily removed, the selective rapture on the second surface 400 is easily removed. Then, in the N-th round and subsequent rounds of processing cycles, since th e selective rapture is hardly present on the second surface 400, the selective rapture is u nlikely to occur even if the second gas with low etching properties is used. In contrast, t he substance X is unlikely to be removed on the first surface 300. That is, the selectivity and the film formation rate may be improved.

An example in which a film is formed using a batch-type substrate processing app aratus capable of processing a plurality of substrates at a time has been described in the above-described embodiments. The present disclosure is not limited to the above-descri bed embodiments, but may be suitably applied, for example, to a case where a film is for med using a single-wafer type substrate processing apparatus capable of processing a si ngle substrate or several substrates at a time. In addition, an example in which a film is formed using a substrate processing apparatus provided with a hot-wall-type process fur nace has been described in the above-described embodiments. The present disclosure is not limited to the above-described embodiments, but may be suitably applied to a case where a film is formed using a substrate processing apparatus provided with a cold-wall -type process furnace.

The above-described processing sequences may be performed consecutively (in-si *tu*) in the same process chamber (process container). Further, at least one process and a ny other process of the above-described processing sequences may be performed (*ex-sit* u) in different process chambers (process container). In either case, the same effects as those of the above-described embodiments may be obtained. Further, when these proce sses are performed *in-situ,* contamination of the substrate, changes in the surface state 0 f the substrate or the like, which may occur when the substrate is unloaded out of the pr ocess chamber between processes or loaded into the process chamber between processe s, may be suppressed. Further, when these processes are performed *in-situ,* the transiti on time between processes may be shortened. On the other hand, when these processes are performed *ex-situ,* the processes may be performed in parallel in different process c hambers, and productivity may be increased accordingly.

Even in the case of using these substrate processing apparatuses, each process m ay be performed according to the same processing procedures and process conditions as those in the above-described embodiments, and the same effects as those of the above-d escribed embodiments may be obtained.

The above-described embodiments may be used in proper combination. The pro cessing procedures and process conditions used in this case may be the same as, for exa mple, the processing procedures and process conditions in the above-described embodi ments.

The embodiments of the present disclosure have been described in detail in the a bove. However, the embodiments of the present disclosure are not limited to the above-described embodiments, and may be changed in various ways without departing from th e spirit of the present disclosure.

According to the present disclosure in some embodiments, it is possible to form a film on a certain surface of a substrate preferentially over other surfaces.

While certain embodiments have been described, these embodiments have been presented by way of example only, and are not intended to limit the scope of the disclos ures. Indeed, the embodiments described herein may be embodied in a variety of other forms. Further, various omissions, substitutions and changes in the form of the embodi ments described herein may be made without departing from the spirit of the disclosure s. The accompanying claims and their equivalents are intended to cover such forms or modifications as would fall within the scope and spirit of the disclosures.

## Claims

1. A method of processing a substrate (200), comprising:
forming a film (500) containing a first element on at least a portion of a substrate (200) having a first surface (300) and a second surface (400), which are made of different substances, by performing a first cycle a first number of times, the first cycle including non-simultaneously performing:
(a1) supplying a first gas containing the first element to the substrate (200) to form a substance X containing the first element on the at least a portion of the substrate (200); and
(a2) supplying a first reaction gas, which reacts with the substance X, to the substrate (200),
wherein an incubation time of the first gas on the second surface (400) is longer than an incubation time of the first gas on the first surface (300), and
wherein in (a1), at least a portion of the substance X formed on the substrate (200) is removed.

2. The method of Claim 1, wherein the first surface (300) is made of a conductive substance, the second surface (400) is made of a non-conductive substance, and the film (500) is made of a conductive substance.

3. The method of Claim 2, wherein in (a1), the substance X formed on the second surface (400) is removed preferentially over the non-conductive substance.

4. The method of Claim 1, further comprising:
performing a second cycle a second number of times, the second cycle including performing:
(b1) supplying a second gas containing the first element to the substrate (200) to form the substance X on the at least a portion of the substrate (200); and
(b2) supplying a second reaction gas, which reacts with the substance X, to the substrate (200).

5. The method of Claim 4, wherein in (b1), the at least a portion of the substance X formed on the substrate (200) is removed, and
wherein (b1) is performed under a condition in which the substance X formed on the substrate (200) is more easily removed than in (a1).

6. The method of Claim 5, wherein a partial pressure of the second gas in a space in which the substrate (200) is placed in (b1) is larger than a partial pressure of the first gas in the space in which the substrate (200) is placed in (a1).

7. The method of Claim 5, wherein a processing cycle including the first cycle performed the first number of times and the second cycle performed the second number of times is performed a plurality of times,
wherein a N-th round and subsequent rounds of processing cycles are performed under conditions different from a (N-1)-th round and earlier rounds of processing cycles with respect to ease of removal of the substance X formed on the substrate (200), and
wherein N is an integer of 2 or more.

8. The method of Claim 7, wherein the N-th round and subsequent rounds of processing cycles are different from the (N-1)th round and earlier rounds of processing cycles in at least one of the first number of times and the second number of times.

9. The method of Claim 7, wherein the N-th round and subsequent rounds of processing cycles are different from the (N-1)th round and earlier rounds of processing cycles in at least one of the supply time of the first gas in (a1) and the supply time of the second gas in (b1).

10. The method of Claim 7, wherein the N-th round and subsequent rounds of processing cycles are different from the (N-1)th round and earlier rounds of processing cycles in at least one of a partial pressure of the first gas in the space in which the substrate (200) is placed in (a1) and a partial pressure of the second gas in the space in which the substrate (200) is placed in (b1).

11. The method of any one of Claims 1 to 10, wherein the first gas contains a metal element as the first element and a halogen element.

12. The method of Claim 11, wherein the first gas is one selected from the group consisting of a MoO₂Cl₂ gas, a MoOCl₄ gas, a MoCl₅ gas, and a MoCl₄ gas.

13. A method of manufacturing a semiconductor device, comprising the method of Claim 1.

14. A substrate processing apparatus (100) comprising:
a first gas supply system configured to supply a first gas containing a first element to a substrate (200) having a first surface (300) and a second surface (400), which are made of different substances;
a first reaction gas supply system configured to supply a first reaction gas, which reacts with a substance X containing the first element, to the substrate (200); and
a controller (121) configured to be capable of controlling the first gas supply system and the first reaction gas supply system so as to perform a process including:
forming a film (500) containing the first element on the at least a portion of the substrate (200) by performing a first cycle a first number of times, the first cycle including non-simultaneously performing:
(a1) supplying the first gas to the substrate (200) to form the substance X on at least a portion of the substrate (200); and
(a2) supplying the first reaction gas to the substrate (200),
wherein an incubation time of the first gas on the second surface (400) is longer than an incubation time of the first gas on the first surface (300), and
wherein in (a1), at least a portion of the substance X formed on the substrate (200) is removed.

15. A program that causes, by a computer, a substrate processing apparatus (100) to perform a program comprising:
forming a film (500) containing a first element on at least a portion of a substrate (200) having a first surface (300) and a second surface (400), which are made of different substances, by performing a first cycle a first number of times, the first cycle including non-simultaneously performing:
(a1) supplying a first gas containing the first element to the substrate (200) to form a substance X containing the first element on the at least a portion of the substrate (200); and
(a2) supplying a first reaction gas, which reacts with the substance X, to the substrate (200),
wherein an incubation time of the first gas on the second surface (400) is longer than an incubation time of the first gas on the first surface (300), and
wherein in (a1), at least a portion of the substance X formed on the substrate (200) is removed.
